Europäisches Patentamt

European Patent Office

Office européen des brevets

(11) Veröffentlichungsnummer: **0 368 128**

**A2**

(12) **EUROPÄISCHE PATENTANMELDUNG**

(21) Anmeldenummer: **89120230.1**

(22) Anmeldetag: **01.11.89**

(51) Int. Cl.5: **G01D 5/243**

(30) Priorität: **02.11.88 DE 3837114**

(43) Veröffentlichungstag der Anmeldung:
**16.05.90 Patentblatt 90/20**

(84) Benannte Vertragsstaaten:
**DE ES FR GB IT SE**

(71) Anmelder: **DAIMLER-BENZ AKTIENGESELLSCHAFT**
**Mercedesstrasse 136**
**D-7000 Stuttgart 60(DE)**

(72) Erfinder: **Burghoff, Heinz-Georg, Dr. Dipl.-Phys.**
**Breslauer Strasse 3**
**D-7313 Reichenbach(DE)**
Erfinder: **Leiber, Heinz, Dipl.-Ing.**
**Theodor-Heuss-Strasse 34**
**D-7141 Oberriexingen(DE)**
Erfinder: **Adomat, Rolf, Dipl.-Ing.**
**Friedrichshafner Strasse 39**
**D-7997 Immenstaad(DE)**
Erfinder: **Ulke, Walter, Dipl.-Ing.**
**Moltkestrasse 34**
**D-7990 Friedrichshafen(DE)**
Erfinder: **Butscher, Karl-Heinz**
**Mörikestrasse 7**
**D-7994 Langenargen(DE)**
Erfinder: **Hasel, Oskar**
**Am Schwarzenbach 24**
**D-7988 Wangen(DE)**

(54) **Schaltung zur Auswertung induktiver Sensoren.**

(57) Die Erfindung betrifft eine Oszillatorschaltung zur Auswertung induktiver Sensoren, insbesondere unter Verwendung von Mikroprozessoren. Die zu messende Induktivität liegt im Rückkopplungszweig eines Komparators und die Komparatorausgangsspannung wird dem Prozessor zugeführt.

Fig. 3

## Schaltung zur Auswertung induktiver Sensoren

Die Erfindung betrifft eine Oszillatorschaltung zur Auswertung induktiver Sensoren, insbesondere unter Verwendung von Mikroprozessoren.

In zunehmendem Maße werden für Steuer- und Regelungsaufgaben, beispielsweise im Kraftfahrzeug, elektronische Schaltungen eingesetzt. Als Bindeglied zwischen Elektronik und physikalischer Meßgröße kommt dabei der Sensorik eine besondere Bedeutung zu.

Bevorzugt werden induktive Komponenten eingesetzt, die kontaktlos arbeiten und deshalb sehr betriebssicher und zuverlässig sind. Sie eignen sich durch unterschiedliche Formgebung zur Erfassung der verschiedenen physikalischen Parameter, wie beispielsweise Drehzahl, Winkel, Beschleunigung, Füllstand, Durchflußmenge, Position oder Wegdifferenz. Das eigentliche Meßproblem besteht darin, die Induktivität L einer Spule zu ermitteln, die ein Maß für die interessierende physikalische Größe ist.

Da oftmals Prozessoren die Steuer- und Regelungsaufgaben übernehmen, bietet sich die Anwendung von prozessororientierten Auswerteverfahren an. Eine analoge Schaltung setzt dabei die Größe der Induktivität L in eine Zeit- oder Frequenzinformation um, die auf einfache Weise mittels Prozessor erfasst werden kann. Dabei bietet sich die Möglichkeit, mehrere Sensoren von einem Prozessor auswerten zu lassen. Gleichzeitig wird die größtmögliche Flexibilität und ein geringer Aufwand an externen Elementen gewährleistet.

Bekannte Auswerteverfahren und Schaltungen lassen sich in zwei prinzipiell verschiedene Gruppen einteilen:

Aus der EP 0 207 218 A2 und der EP 0 126 846 A2 ist das Prinzip der passiven Netzwerke bekannt. Dabei regt der Prozessor ein Netzwerk, das einen induktiven Weggeber als frequenzbestimmendes Element enthält, mit einer Sprungfunktion an. Zur Auswertung wird über einen Komparator dem Prozessor das Erreichen eines vorgegebenen Wertes angezeigt. Die Zeitdifferenz zwischen Sprungerregung und dem Erreichen der Schaltschwelle stellt eine Information über die Große der Meßspule dar.

Das Prinzip der Oszillatorschaltung ist aus DE-OS 29 24 092 und DE-S 20 46 336 bekannt. Dabei wird ein induktiver Weggeber im Rückkopplungszweig einer Verstärkerstufe eingesetzt, die dadurch zum Schwingen angeregt wird. Dabei können sowohl analoge Stufen mit Transistoren oder Operationsverstärkern, als auch digitale Stufen mit Invertern oder Komparatoren eingesetzt werden. Zur Auswertung wird die Schwingfrequenz per Prozessor bestimmt, indem entweder die Periodendauer einer Schwingung oder die Anzahl der Schwingungen während einer Torzeit gemessen wird.

Die benötigte Zeit- oder Frequenzmessung erfolgt jeweils durch den Prozessor. Beim erstgenannten Prinzip wird der Prozessor zusätzlich dazu benötigt, die Sprungfunktion zur Anregung des passiven Netzwerkes zu erzeugen. Nachteilig an vorgenannten Schaltungsprinzipien ist der hohe Aufwand an Bauelementen und der negative Einfluß des Serienwiderstandes. Dieser Serienwiderstand muß in den bekannten Schaltungen temperaturkompensiert sein, da nur dann über einen großen Temperaturbereich eine hohe Meßgenauigkeit erzielt werden kann. Die mit bekannten Schaltungen erhaltenen Meßwerte werden durch parasitäre Kapazitäten, wie sie beispielsweise im Kraftfahrzeug durch Leitungen etc. auftreten, negativ beeinflusst.

Aufgabe der Erfindung ist es, eine Schaltung anzugeben, die ein sicheres Auswerten induktiver Sensoren mit wenigen Bauteilen und hoher Meßgenauigkeit gewährleistet.

Diese Aufgabe wird durch eine Schaltung nach Anspruch 1 gelöst.

Ausgestaltungen sind Bestandteile von Unteransprüchen.

Die Erfindung wird anhand von Figuren verdeutlicht.

Es zeigen:

Figur 1 das Ersatzschaltbild für einen induktiven

Sensor,

Figur 2 das Schaltbild der mitgekoppelten Oszillatorschaltung,

Figur 3 das Schaltbild nach Figur 2 mit einem Komparator mit Open-Collector-Ausgang und Mikroprozessor,

Figur 4 Kurvenverläufe beim mitgekoppelten Komparator

über der Zeit,

Figur 5 die Schwingfrequenz des mitgekoppelten Komparators als Funktion der Sensorinduktivität,

Figur 6 den Einfluß der Betriebsspannung $U_B$ auf die Periodendauer T bei der mitgekoppelten Oszillatorschaltung,

Figur 7 den Einfluß des Serienwiderstandes $R_S$ des induktiven Sensorelements auf die Periodendauer T bei der mitgekoppelten Oszillatorschaltung,

Figur 8 das Schaltbild der mitgekoppelten Oszillatorschaltung mit parasitären Kapazitäten,

Figur 9 das Schaltbild der mitgekoppelten Oszillatorschaltung unter Verwendung eines Transistors.

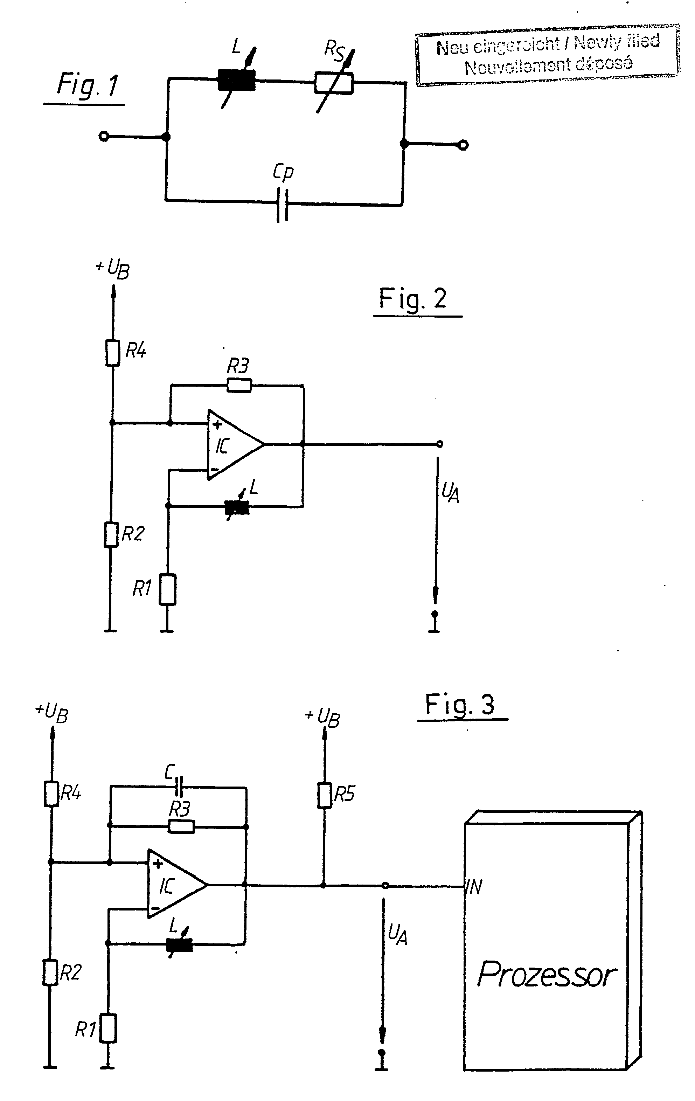

Die Figur 1 zeigt das elektrische Ersatzschaltbild eines induktiven Sensors mit einer veränderlichen Induktivität, deren typische Größe bei einigen 10 mH liegt. Der Serienwiderstand $R_S$ ist ebenfalls veränderlich dargestellt, da die Leitfähigkeit des Wicklungsmaterials ebenso wie die Wirbelstromverluste nicht konstant sind. Parallel zu der Serienschaltung aus L und $R_S$ ist der die Kapazität der Windungen charakterisierende Kondensator Cp dargestellt.

Die Figur 2 zeigt die erfindungsmäße Oszillatorschaltung, bestehend aus einem Komparator-IC, vier Widerständen $R_1$ ... $R_4$ und der zu messenden Induktivität L. Beispielhafte Werte für verwendete Bauelemente sind angegeben.

In der überwiegenden Zahl der Anwendungsfälle wird ein Komparator mit Open-Collector-Ausgang vorliegen. Dann wird der Pull-up-Widerstand $R_5$ zwischen Komparatorausgang und $U_B$ angeschlossen. Dies zeigt Figur 3. Dort ist auch parallel zu $R_3$ ein Kondensator C dargestellt.

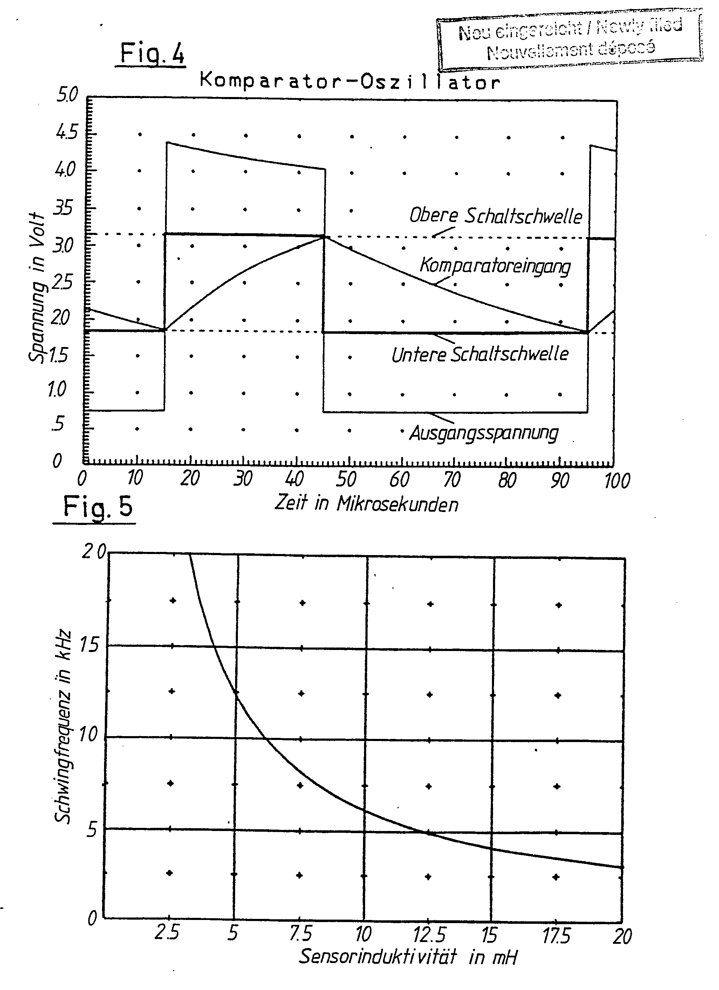

Die theoretische Behandlung des Komparator-Oszillators ergibt für den eingeschwungenen Zustand die in Figur 4 dargestellten typischen Signalverläufe. Bei Erreichen der unteren Schaltschwelle der Komparatoreingangsspannung steigt die Komparatorausgangsspannung sprungartig an. Die Komparatoreingangsspannung folgt verzögert nach, bis sie die obere Schaltschwelle erreicht. Dann geht die Ausgangsspannung wieder auf den ursprünglichen Minimalwert zurück und auch hier folgt die Eingangsspannung wieder verzögert nach.

Figur 5 zeigt die Schwingfrequenz als Funktion der Sensorinduktivität für eine beispielhafte Dimensionierung. Einem Auswerteprozessor ist eine solche Kennlinie vorgegeben, woraus dieser bei bestimmten Frequenzen die Induktivitätswerte bestimmt. Bei der Berechnung wurde für den Komparator ein Modell mit Open-Collector-Ausgang zugrundegelegt, das für die Sättigungsspannung des Ausgangstransistors einen stromunabhängigen Wert $U_{A(min)}$ berücksichtigt. Die gezeigten Kurvenverläufe gelten unter der Bedingung, daß $R_1$ sehr viel größer als $R_S$ dimensioniert ist und der Einfluß des Serienwiderstandes $R_S$ vernachlässigt werden kann. Bei dieser Dimensionierung ergeben sich für die Signale bestimmende Zeitkonstanten, die bei direkter Messung per Prozessor zu unerlaubt hohen Meßfehlern führen werden.

Die vorgeschlagene Oszillator-Schaltung ermöglicht dem Prozessor die Vermessung über mehrere Schwingungsperioden, so daß mit einfachen Timerfunktionen die gewünschte Meßgenauigkeit erzielt werden kann.

Der Einfluß der Betriebsspannung $U_B$ auf die Periodendauer T ist gering. Nur die minimale Komparatorausgangsspannung $U_{A(min)}$ hat einen geringen Einfluß, was durch eine geeignete Bauelementendimensionierung berücksichtigt werden muß.

Zur exakten Bestimmung der erreichbaren Meßgenauigkeit sind die endlichen Komparatoreigenschaften, wie beispielsweise die stromabhängige Sättigungsausgangsspannung und die endliche Leerlaufverstärkung, ebenso zu berücksichtigen wie die genauen Daten des Meßsensors.

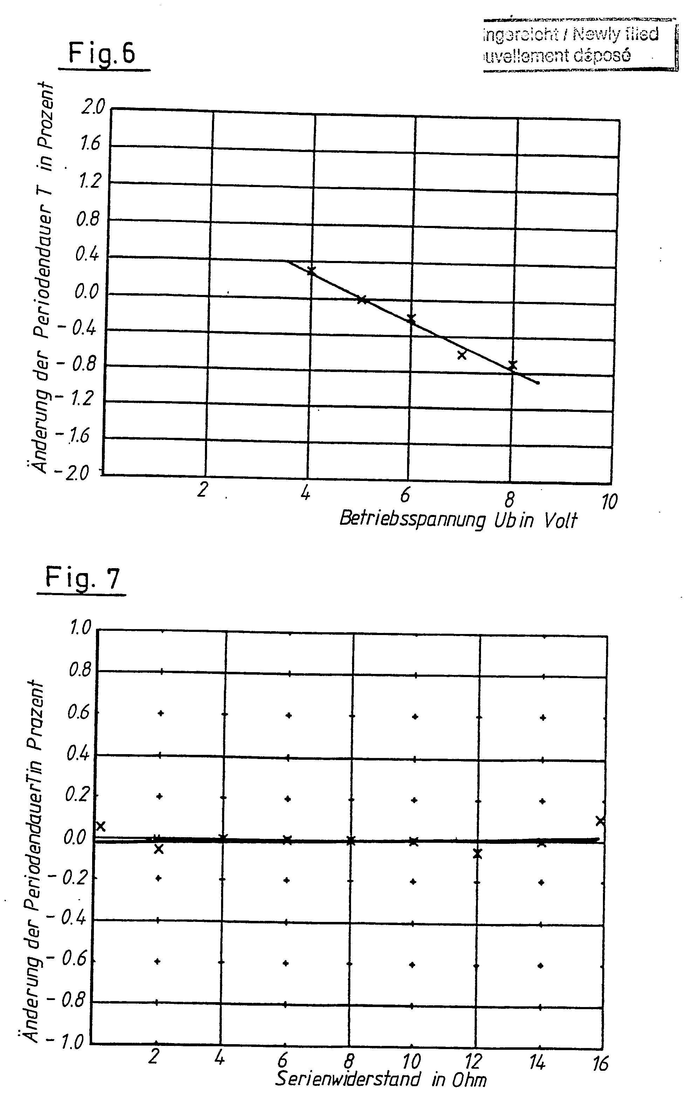

Die in den Figuren 6 und 7 dargestellten Meßergebnisse zeigen den Einfluß der Betriebsspannung und des Serienwiderstandes auf die Periodendauer R. Die hierin dargestellten Meßergebnisse zeigen die große Übereinstimmung mit den theoretisch erwarteten Werten.

Bei vielen Anwendungen wird die Auswerteelektronik räumlich vom Sensorelement getrennt sein. Der Meßgeberanschluß erfolgt über Zuleitungen, die eine Länge von mehreren Metern haben können. Diese Anschlußleitungen, sowie der Sensor selbst, besitzen parasitäre Elemente, deren Einfluß abge schätzt werden soll. Vernachlässigt werden dabei die Zuleitungsinduktivitäten, die um Größenordnungen kleiner als die Induktivitäten eines Meßgebers sind.

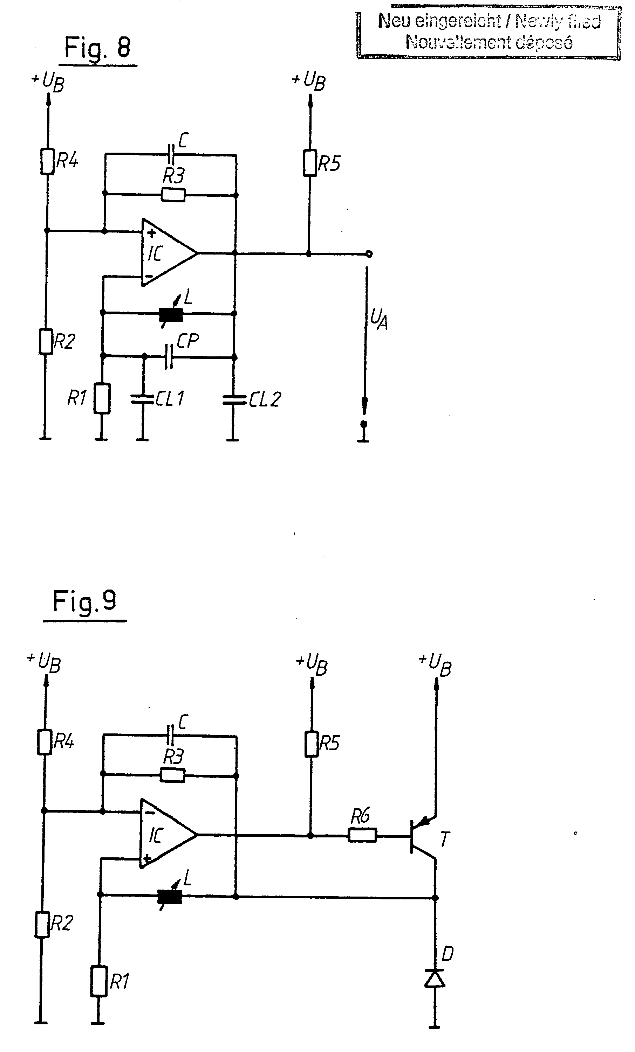

So ergibt sich das Ersatzschaltbild in Figur 8. Die Kapazität der Anschlußleitungen gegen Masse stellen die Kondensatoren $CL_1$ und $CL_2$ dar. Ihre Größe kann abhängig von der Länge und der Lage der Leitungen im nF-Bereich liegen. Der Kondensator Cp repräsentiert die Parallelkapazität zum Sensor.

Durch die Kapazität Cp parallel zum Meßgeber entsteht am invertierenden Komparatoreingang ein zusätzlicher Hochpaßanteil. Für den resultierenden Fehler ist das Verhältnis der Hochpaßzeitkonstante Cp • $R_1$ zur Zeitkonstanten $L/R_1$ maßgebend, die im Idealfall die Schwingfrequenz bestimmt. Die Gleichungen, die das System beschreiben, sind analytisch nicht mehr lösbar.

Anhaltspunkte über die Größenordnung des Fehlers geben aber die folgenden Werte, die die Differenz zwischen dem Kurvenverlauf am invertierenden Eingang des Komparators mit und ohne Parallelkapazität Cp nach einer Zeitspanne L/R beschreiben.

Cp = 30 pF L = 10 mH R = 1 kOhm F = 0.11 %
Cp = 100 pF L = 10 mH R = 1 kOhm F = 0.38 %
Cp = 300 pF L = 10 mH R = 1 kOhm F = 1.20 %

Eine weitere Fehlergröße stellt die Kapazität $CL_1$ dar, die der Komparatorausgangsspannung einen Tiefpaßcharakter verleiht. Bei einem Sprung des Komparatorausgangs von low auf high verläuft die unbelastete Ausgangsspannung $U_A(t)$ gemäß der Form:

$$U_A(t) = (U_{A(min)} - U_B) \cdot \exp(-t/CL_1 \cdot R_S) + U_B$$

Solange die Zeitkonstante $CL_1 \cdot R_S$ sehr klein gegenüber der Zeitkonstanten $L/(R_1 + R_S)$ bleibt,

ist der Einfluß von $CL_1$ zu vernachlässigen.

Wenn die Zuleitungskapazität $CL_1$ größere Werte annimmt, kann durch den Einsatz von Komparatoren mit Gegentaktausgang oder eines zusätzlichen Treibertransistors der Fehler minimiert werden.

Kritischer ist die parasitäre Kapazität $CL_2$ zu bewerten, da sie parallel zum gegenüber $R_S$ hochohmigen Widerstand $R_1$ wirkt und ihr Einfluß nicht durch einfache Schaltungsvariation veringert werden kann. Um vorgegebene Fehlerschranken durch die Auswirkungen der Leitungskapazität an dieser Stelle nicht zu überschreiten, muß der Wider stand $R_1$ entsprechend dimensioniert werden.

Als Ergänzung der in Figur 2 aufgezeigten Schaltung ist es möglich, am Komparatorausgang einen Transistor T anzuschließen, der von diesem gesteuert wird. Dies zeigt Figur 9. Dazu ist notwendig, eine Freilaufdiode D zur Masse hin vorzusehen. Zwischen Komparatorausgang und Transistor ist noch ein zusätzlicher Widerstand $R_6$ vorgesehen. Die Verwendung eines Transistors gewährleistet einen größeren Variationsbereich für den Tiefpaß, der Strom kann größer werden, da er nicht aus dem Komparator, sondern aus der Batterie gezogen wird und damit entstehen definiertere Pegel.

Die mitgekoppelte Oszillatorschaltung ist hinsichtlich des Aufwands an externen Bauelementen, des Temperaturverhaltens, der erzielbaren Genauigkeit und der Ansprüche an die Stabilität der Versorgungsspannung optimal nutzbar. Die Größe der Sensorinduktivität wird in die Periodendauer einer stationären Schwingung umgesetzt, die durch einen Prozessor einfach bestimmt werden kann. Dazu kann ein bereits vorhandener Prozessor benutzt werden, falls er über integrierte Timer-/Counter-Funktionen verfügt. Seine Belastung ist abhängig von der Abtastrate zur Aktualisierung eines Meßwertes und der Zeit für die Periodendauerbestimmung. Bei der Bearbeitung mehrerer Sensoren steigt die Prozessorbelastung annähernd proportional zur Anzahl der Meßgeber. Die praktische Verwendbarkeit des Auswerteprinzips wurde in einer Breadboardschaltung nachgewiesen, wobei sich eine ausgezeichnete Übereinstimmung mit den theoretisch erwarteten Eigenschaften ergab. Besondere Anforderungen (Temperaturkompensation) an den Meßgeber werden nicht gestellt, so daß die Schaltung ohne Probleme an die verschiedensten induktiven Sensoren angeschlossen werden kann.

Anstelle des Mikroprozessors zur Auswertung des Komparatorausgangssignals ist es auch denkbar, an den Komparatorausgang zunächst einen Frequenz - Spannungs-Umwandler anzuschließen, dessen Ausgangssignal einer Auswerteeinrichtung zur Bestimmung der Induktivität des zu messenden Sensors aus der jetzt vorliegenden Spannung zugeführt wird.

## Ansprüche

1. Schaltung zur Auswertung eines induktiven Sensors mit einem Komparator, **gekennzeichnet** durch einen Mitkopplungszweig, bestehend aus drei Widerständen $R_2$, $R_3$ und $R_4$ und einen Rückkopplungszweig, bestehend aus einem Widerstand $R_1$ und der zu bestimmenden Induktivität.

2. Schaltung nach Anspruch 1, dadurch gekennzeichnet, da der Komparator einen Open-Collector-Ausgang aufweist und ein zusätzlicher Widerstand $R_5$ vorgesehen ist.

3. Schaltung nach Ansprüchen 1 oder 2, dadurch gekennzeichnet, da ein Transistor und eine Freilaufdiode vorgesehen sind und über den Transistor der Rückkopplungszweig vom Komparator ansteuerbar ist.

4. Schaltung nach wenigstens einem der vorherigen Ansprüche, dadurch gekennzeichnet, da am Komparatorausgang ein Mikroprozessor vorgesehen ist, der die am Komparator auftretende Rechteckspannung nach Frequenz oder Periodendauer und darüber die gesuchte Induktivität bestimmt.

5. Schaltung nach wenigstens einem der vorherigen Ansprüche, dadurch gekennzeichnet, da am Komparatorausgang ein Frequenz-Spannungs-Umsetzer und an dessen Ausgang eine Auswerteeinrichtung zur Bestimmung der Induktivität vorgesehen ist.

Fig. 1

Neu eingereicht / Newly filed
Nouvellement déposé

Fig. 2

Fig. 3

## Fig. 4

**Komparator-Oszillator**

Obere Schaltschwelle

Komparatoreingang

Untere Schaltschwelle

Ausgangsspannung

Spannung in Volt

Zeit in Mikrosekunden

## Fig. 5

Schwingfrequenz in kHz

Sensorinduktivität in mH

## Fig. 6

Änderung der Periodendauer T in Prozent

2.0
1.6
1.2
0.8
0.4
0.0
- 0.4
- 0.8
- 1.2
- 1.6
- 2.0

2    4    6    8    10

Betriebsspannung Ub in Volt

## Fig. 7

Änderung der Periodendauer T in Prozent

1.0
0.8
0.6
0.4
0.2
0.0
- 0.2
- 0.4
- 0.6
- 0.8
- 1.0

2    4    6    8    10    12    14    16

Serienwiderstand in Ohm

## Fig. 8

## Fig.9